# EUROPEAN PATENT APPLICATION

(11) **EP 4 576 494 A2**
(43) Date of publication of application: **25.06.2025**
(21) Application number: 24221133.2
(22) Date of filing: 18.12.2024
(51) Int. Cl.: H02J 9/06, G01R 31/42

(54) **METHODS AND SYSTEMS FOR PERFORMING HIGH POWER LOAD TESTING OF AN UNINTERRUPTIBLE POWER SUPPLY**

(30) Priority: 19.12.2023 US 202363612093 P; 13.12.2024 US 202418980073
(71) Applicant: Schneider Electric IT Corporation, Foxboro, MA 02035 (US)
(72) Inventor: QUIJADA MOLERO, Marco Antonio, ANDOVER, 01810 (US)
(74) Representative: Plasseraud IP

(57) **Abstract**

A method comprising delivering power from an output of a first uninterruptible power supply (UPS) system to an inlet of a second UPS system; receiving power from an outlet of the second UPS system at an inlet of the first UPS system; and maintaining a magnitude of the power delivered from the output of the first UPS system to the inlet of a second UPS system at a desired level.

## Description

### BACKGROUND

### Field of the Disclosure

At least one example in accordance with the present disclosure relates generally to uninterruptible power supplies and to methods of testing the same.

### Discussion of Related Art

Power devices, such as uninterruptible power supplies (UPS), may be used to provide power to one or more loads. During commissioning of a new UPS system the system may be tested to ensure it is capable of providing a desired magnitude of power for a desired amount of time to a load.

### BRIEF DESCRIPTION OF THE DRAWINGS

Various aspects of at least one embodiment are discussed below with reference to the accompanying figures, which are not intended to be drawn to scale. The figures are included to provide an illustration and a further understanding of the various aspects and embodiments, and are incorporated in and constitute a part of this specification, but are not intended as a definition of the limits of any particular embodiment. The drawings, together with the remainder of the specification, serve to explain principles and operations of the described and claimed aspects and embodiments. In the figures, each identical or nearly identical component that is illustrated in various figures is represented by a like numeral. For purposes of clarity, not every component may be labeled in every figure. In the figures:
FIG. 1A is a block diagram of an uninterruptible power supply (UPS) according to an example;
FIG. 1B is a block diagram of an UPS disposed at a facility according to an example;
FIG. 2 schematically illustrates one arrangement for performance testing a UPS according to an example;
FIG. 3A schematically illustrates another arrangement for performance testing a UPS according to an example;
FIG. 3B schematically illustrates another arrangement for performance testing a UPS according to an example;
FIG. 4 is a flowchart of an example of a method of performing a performance test on a UPS;
FIG. 5 illustrates a UPS system disposed in a portable container according to an example;
FIG. 6 illustrates a power profile that may be utilized during performance testing of a UPS system according to an example; and
FIG. 7 illustrates voltage readings during a transient test of a UPS system according to an example.

### DETAILED DESCRIPTION

Examples of the methods and systems discussed herein are not limited in application to the details of construction and the arrangement of components set forth in the following description or illustrated in the accompanying drawings. The methods and systems are capable of implementation in other embodiments and of being practiced or of being carried out in various ways. Examples of specific implementations are provided herein for illustrative purposes only and are not intended to be limiting. In particular, acts, components, elements and features discussed in connection with any one or more examples are not intended to be excluded from a similar role in any other examples.

Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items.

References to "or" may be construed as inclusive so that any terms described using "or" may indicate any of a single, more than one, and all of the described terms. In addition, in the event of inconsistent usages of terms between this document and documents incorporated herein by reference, the term usage in the incorporated features is supplementary to that of this document; for irreconcilable differences, the term usage in this document controls.

An uninterruptible power supply (UPS) may be used to provide continuity of power to loads which are normally powered by, for example, utility AC mains power, and which a user finds downtime due to issues with the AC mains power supply undesirable or unacceptable. A UPS typically includes one or more sensors to monitor the quality of the mains power supply and functionality to switch the supply of power to a backup power source if the quality of the mains power supply drops below an acceptable level. UPSs may be used as backup power supplies to multiple kinds of loads. Example of loads that commonly are provided with a UPS for continuity of power are computer servers. A data center may include racks for holding one or more computer servers as well as one or more UPSs to provide backup power to the one or more computer servers.

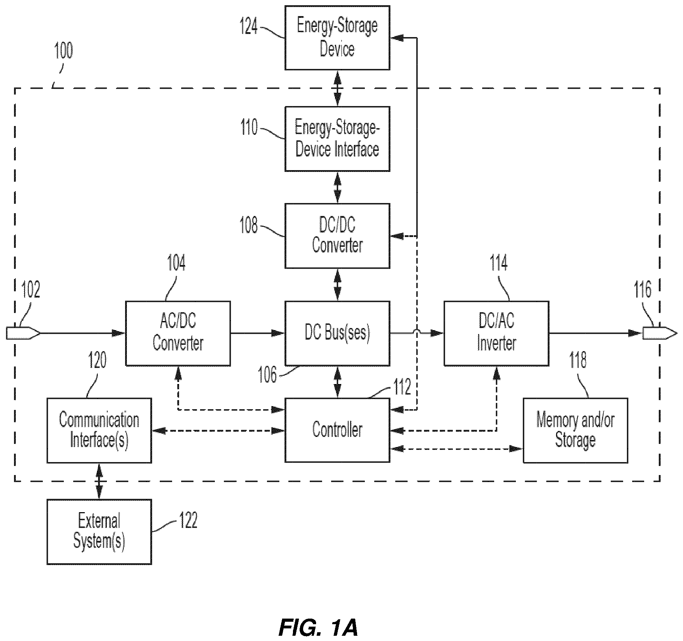

FIG. 1A is a block diagram of a UPS 100 according to an example. In another example, FIG. 1A may illustrate a block diagram of one of several power modules of a UPS. The UPS 100 includes an input 102, an AC/DC converter 104, one or more DC busses 106, a DC/DC converter 108, an energy-storage-device interface 110, at least one controller 112, a DC/AC inverter 114, an output 116, a memory and/or storage 118, and one or more communication interfaces 120, which may be communicatively coupled to one or more external systems 122.

The input 102 is coupled to the AC/DC converter 104 and to an AC power source (not pictured), such as an AC mains power supply. The AC/DC converter 104 is coupled to the input 102 and to the one or more DC busses 106, and is communicatively coupled to the controller 112. The one or more DC busses 106 are coupled to the AC/DC converter 104, the DC/DC converter 108, and to the DC/AC inverter 114, and are communicatively coupled to the controller 112. The DC/DC converter 108 is coupled to the one or more DC busses 106 and to the energy-storage-device interface 110, and is communicatively coupled to the controller 112. The energy-storage-device interface 110 is coupled to the DC/DC converter 108, and is configured to be coupled to at least one energy-storage device 124 and/or another energy-storage device.

In some examples, the energy-storage device 124 is external to the UPS 100 and coupled to the UPS 100 via the energy-storage-device interface 110. In various examples, the UPS 100 may include one or more energy-storage devices, which may include the energy-storage device 124. The energy-storage device 124 may include one or more batteries, capacitors, flywheels, or other energy-storage devices.

The DC/AC inverter 114 is coupled to the one or more DC busses 106 and to the output 116, and is communicatively coupled to the controller 112. The output 116 is coupled to the DC/AC inverter 114, and to an external load (not pictured). The controller 112 is communicatively coupled to the AC/DC converter 104, the one or more DC busses 106, the DC/DC converter 108, the energy-storage-device interface 110, the DC/AC inverter 114, the memory and/or storage 118, and the communication interfaces 120.

The input 102 is configured to be coupled to an AC mains power source and to receive input AC power having an input voltage level. The UPS 100 is configured to operate in different modes of operation based on the input voltage of the AC power provided to the input 102. The controller 112 may determine a mode of operation in which to operate the UPS 100 based on whether the input voltage of the AC power is acceptable. The controller 112 may include or be coupled to one or more sensors configured to sense parameters of the input voltage. For example, the controller 112 may include or be coupled to one or more sensors configured to sense a voltage level of the AC power received at the input 102.

When AC power provided to the input 102 is acceptable (for example, by having parameters, such as an input voltage value, that meet specified values, such as by falling within a range of acceptable input voltage values), the controller 112 controls components of the UPS 100 to operate in a normal mode of operation. In the normal mode of operation, AC power received at the input 102 is provided to the AC/DC converter 104. The AC/DC converter 104 converts the AC power into DC power and provides the DC power to the one or more DC busses 106. The one or more DC busses 106 distribute the DC power to the DC/DC converter 108 and to the DC/AC inverter 114. The DC/DC converter 108 converts the received DC power and provides the converted DC power to the energy-storage-device interface 110. The energy-storage-device interface 110 receives the converted DC power, and provides the converted DC power to the energy-storage device 124 to charge the energy-storage device 124. The DC/AC inverter 114 receives DC power from the one or more DC busses 106, converts the DC power into regulated AC power, and provides the regulated AC power to the output 116 to be delivered to a load.

When AC power provided to the input 102 from the AC mains power source is not acceptable (for example, by having parameters, such as an input voltage value, that do not meet specified values, such as by falling outside of a range of acceptable input voltage values), the controller 112 controls components of the UPS 100 to operate in a backup mode of operation. In the backup mode of operation, DC power is discharged from the energy-storage device 124 to the energy-storage-device interface 110, and the energy-storage-device interface 110 provides the discharged DC power to the DC/DC converter 108. The DC/DC converter 108 converts the received DC power and distributes the DC power amongst the one or more DC busses 106. For example, the DC/DC converter 108 may evenly distribute the power amongst the one or more DC busses 106. The one or more DC busses 106 provide the received power to the DC/AC inverter 114. The DC/AC inverter 114 receives the DC power from the one or more DC busses 106, converts the DC power into regulated AC power, and provides the regulated AC power to the output 116.

The controller 112 may store information in, and/or retrieve information from, the memory and/or storage 118. For example, the controller 112 may store information indicative of sensed parameters (for example, input-voltage values of the AC power received at the input 102) in the memory and/or storage 118. The controller 112 may further receive information from, or provide information to, the communication interfaces 120. The communication interfaces 120 may include one or more communication interfaces including, for example, user interfaces (such as display screens, touch-sensitive screens, keyboards, mice, track pads, dials, buttons, switches, sliders, light-emitting components such as light-emitting diodes, sound-emitting components such as speakers, buzzers, and so forth configured to output sound inside and/or outside of a frequency range audible to humans, and so forth), wired communication interfaces (such as wired ports), wireless communication interfaces (such as antennas), and so forth, configured to exchange information with one or more systems, such as the external systems 122, or other entities, such as human beings. The external systems 122 may include any device, component, module, and so forth, that is external to the UPS 100, such as a server, database, laptop computer, desktop computer, tablet computer, smartphone, central controller or data-aggregation system, other UPSs, and so forth.

Although illustrated as separate components, it is to be appreciated that in some embodiments, the controller 112 and the memory and/or storage 118 may be integrated together in a single component.

Examples of a UPS as disclosed herein may include various controllers, such as the controller 112, that may execute various operations discussed herein. Using data stored in associated memory and/or storage 118, the controller 112 may execute one or more instructions stored on one or more non-transitory computer-readable media, that may be included in or that may be the memory and/or storage 118, which the controller 112 may include and/or be coupled to, that may result in manipulated data. The memory and/or storage 118 may be or may include any one or more of a hard drive, SRAM, flash memory, or any other form of memory or data storage known in the art. In some examples, the controller 112 may include one or more processors or other types of controllers. In one example, the controller 112 is or includes at least one processor, for example, one or more digital signal processors, one or more microcontrollers, one or more system on a chip (SOC) device, or one or more general-purpose computer processors such as a Core^{®} processor from Intel. In another example, the controller 112 performs at least a portion of the operations discussed above using one or more application-specific integrated circuits tailored to perform particular operations in addition to, or in lieu of, a general-purpose processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

In some examples, the UPS 100 may be a multi-phase UPS, such as a three-phase UPS. For example, the input 102 may include multiple inputs each configured to receive a respective phase line (and, in some examples, the multiple inputs may include a return input). Accordingly, although examples of FIG. 1A may be described with respect to a single connection and/or single-phase operation, it is to be appreciated that multi-phase operation is within the scope of FIG. 1A and the disclosure as a whole.

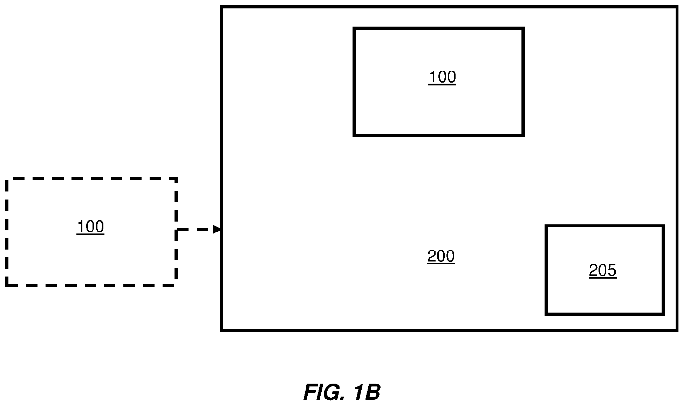

The UPS 100 may be installed internal or external to a facility or enclosure 200 housing equipment that the UPS is intended to supply backup power to. (FIG. 1B.) The facility or enclosure 200 may additionally house mechanical loads 205, for example, a cooling system such as a computer room air conditioner (CRAC) unit, direct expansion unit, or chiller and racks housing electronic equipment (not illustrated). If installed external to the facility or enclosure 200, the UPS may be housed in a container, for example, a 20 foot shipping container.

When a new UPS system is being commissioned at a facility, for example, a data center, or at a manufacturer prior to delivery to a facility, a customer or operator of the facility may determine what amount of power that the facility may require to maintain at least its most important operations in the event of failure of AC mains power and that the UPS should be capable of providing. The customer may also specify an amount of time which they desire the UPS to be capable of providing the specified amount of power for. The UPS may be configured with, for example, an appropriately sized energy storage device to meet the customer's specifications.

To provide confidence that a UPS at a facility will be capable of meeting a customer's specifications with respect to magnitude of power supplied the UPS may be subjected to a performance test in which it is operated to provide the specified magnitude of power or a magnitude of power above that which the facility may require in the event of mains failure. During the performance test operational parameters of components of the UPS may be checked or, in some instances, continuously monitored to confirm that the components function properly when delivering the power. For example, one or more components of the UPS may be checked or monitored to verify that the component does not heat to levels above specification during the performance test while the UPS is supplying the power.

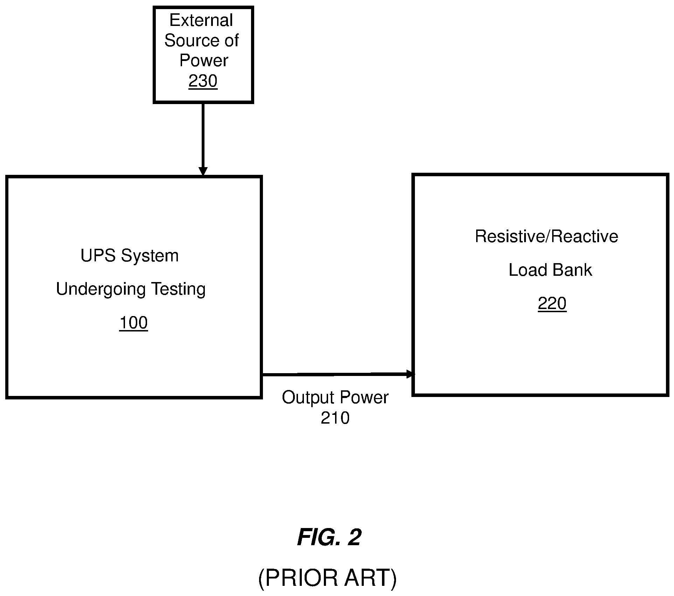

One conventional method and arrangement for performance testing a UPS is illustrated in FIG. 2. The UPS 100 is turned on and delivers the desired magnitude of power 210 for the performance test to a resistive and/or reactive load bank 220 which dissipates the power 210, for example, in the form of heat.

In some instances the performance test is run for a time period exceeding that which the UPS system is designed to provide backup power to the facility, for example, up to multiple weeks to thoroughly test the UPS system. In a new facility or one that is undergoing commissioning, AC mains power that is capable of providing sufficient power for the UPS performance test, for example, 1.5 MW or more may not be available. The external source of power 230 may thus be a fuel-consuming source of power, for example, a diesel generator.

A disadvantage of the system and method of FIG. 2 is that supplying the desired amount of power with a diesel generator for an extended period of time for which the performance test may be run may consume a significant amount of fuel. In one example a genset designed to provide 1.2 MW of power may consume over 600 gallons of diesel fuel per day. This is not only costly, but also harmful to the environment due to the carbon dioxide produced from combustion of the fuel by the generator. Further, all power produced by the external source of power 230 is wasted by being dissipated in the load bank 220.

Aspects and embodiments disclosed herein provide a system and method of performance testing of a UPS system that eliminates or at least reduces the magnitude of these disadvantages. In some embodiments, systems and methods disclosed herein for performance testing of a UPS system may utilize about 10% - 12% of the external power draw of a system as shown in FIG. 2, which may substantially reduce or eliminate the use of a generator and its associated carbon dioxide emissions and noise generation to supply such power.

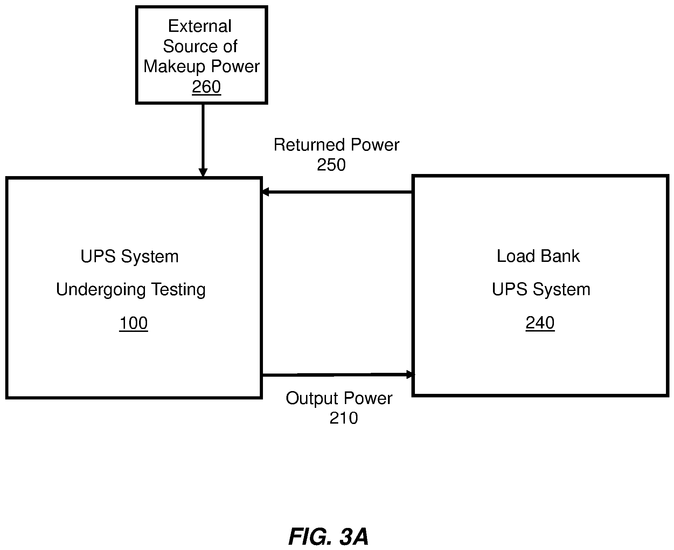

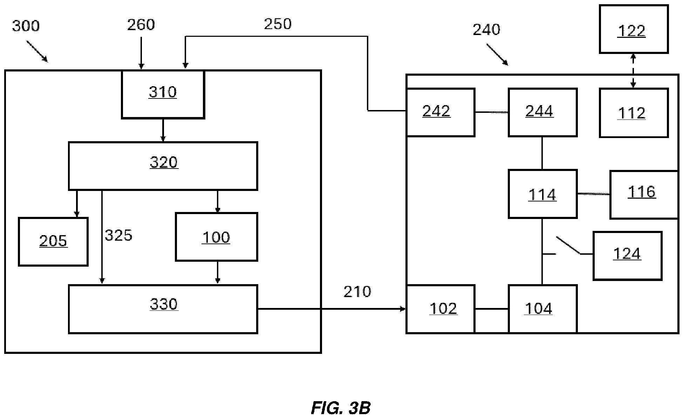

FIGS. 3A and 3B schematically illustrates an embodiment of a system and method for performance testing a UPS system by connecting the output of the UPS system to the input of a second UPS system and operating the second UPS system to function as a load bank. In the embodiment illustrated in FIG. 3A a desired amount of test power 210 is delivered from an output of a first UPS system 100 undergoing testing to a power inlet of a second UPS system 240 that functions as a load bank. In some embodiments, the second UPS system 240 is a used system that has exceeded a specified time in the field for a particular implementation but which still functions sufficiently well to be utilized as a load bank UPS system 240.

The power 210, subject to some losses in the second UPS system 240, passes through the second UPS system 240 and is received as returned power 250 from an outlet of the second UPS system 240 at an inlet of the first UPS system 100. The second UPS system 240 is operated, for example, by executing instructions provided to its controller 112 from an external system 122, in some cases through a communications interface (not shown in FIG. 3B) to act as a controlled short circuit between the power outlet and power inlet of the first UPS system 100. The second UPS system 240 back feeds power that was delivered by the first UPS system 100 to the second UPS system 240 back from the second UPS system 240 to the first UPS system 100. Power is recirculated through the first and second UPS systems 100, 240 rather than being dissipated in a load bank 220 as illustrated in the system and method of FIG. 2. The second UPS system 240 may be controlled to, for example, apply/recirculate power to the first UPS system 100 at a predetermined power level or in steps and/or control how power recirculated between the first UPS system 100 and second UPS system 240 is increased or decreased over time (ramped up or down), for example, how much time it takes to go from zero power being recirculated to the maximum test power being recirculated. The second UPS system 240 may be controlled to maintain power circulating between the first UPS system 100 and second UPS system 240 at a magnitude equal or greater than a rated capacity of the first UPS system 100 so that the first UPS system 100 is tested at its full capacity. In some embodiments, instructions may be provided from an external system 122 or an operator to a controller of the second UPS system that sets the voltage at which power is delivered from the first UPS system 100 to the second UPS system 240 at a desired level, for example, 480V, 415V, 400V, 380V, or another desired voltage.

The recirculated power will be subjected to some resistive and/or reactive losses while being recirculated through the first and second UPS systems 100, 240, however, these losses may be minimal, for example, about 10% of the total test power. Makeup power is thus drawn from an external source 230 into a power inlet of the first UPS system 100, which may in some instances be the same power inlet the returned power 250 is provided to or may be a physically distinct power inlet. As the term is used herein a power inlet may include more than one physically distinct power inlet connection. The first UPS 100 is thus able to maintain the magnitude of the power delivered from the output of the first UPS system 100 to the inlet of the second UPS system 240 by drawing power from the external source 260 into the inlet of the first UPS system 100 in amount sufficient to make up for power losses exhibited in a current loop including the first and second UPS systems 100, 240. In some instances the amount of makeup power is sufficiently low that it can be supplied by limited mains utility power that may be available at the facility. Even if mains power is unavailable, the makeup power may be provided by a generator configured to deliver power to the inlet of the first UPS system 100, but the amount of fuel consumed to provide the makeup power may be about 90% less than the power provided by the external source 230 of FIG. 2. In some embodiments, a control system of the UPS test system may maintain the magnitude of the power delivered from the output of the first UPS system 100 to the inlet of the second UPS system 240 by controlling operation of the generator.

It should be appreciated that in alternate embodiments, the makeup power may be provided to the second UPS system 240 instead of or in addition to the first UPS system 100, or it may be provided anywhere in the current loop including the first and second UPS systems 100, 240.

In some embodiments, the UPS 100 may be disposed within a power enclosure along with additional equipment. As illustrated in FIG. 3B, a power enclosure 300 may receive input power 260 at an input 310 that may include one or more circuit breakers, and voltage, current, and/or power quality meters. Power may be supplied from the input 310 to a bank of input circuit breakers and switchboard 320 which may selectively provide power to the UPS 100 or to a bank of output circuit breakers and switchboard 330 through a bypass line 325. The UPS 100 provides power to the bank of output circuit breakers and switchboard 330 which in turn provides output power 210 to a main input 102 of the second UPS 240. In addition to features of the UPS 100 illustrated in FIG. 1A such as the main input 102, rectifier (AC/DC converter) 104, controller 112, inverter (DC/AC converter) 114, main output 116, and energy storage device 124, and in some cases other features of the UPS of FIG. 1A not illustrated in FIG. 3B, the second UPS 240 may include a bypass input 242 and static switch 244. During testing of the first UPS 100, the main output 116 of the second UPS 240 is not utilized and power may flow through the main input 102, rectifier 104, inverter 114, and static switch 244 and output as the returned power 250 to the input 310 of the power enclosure 300 through the bypass input 242 of the second UPS 240. The bypass input 242 thus functions as the output of the second UPS 240 when it is used for testing the first UPS 100.

During testing of the UPS 100 the additional components of the power enclosure 300 or within the facility or enclosure 200 may also be tested. For example, one or more operating parameters of the input or output breakers and switchboards 320, 330 or of a mechanical load 205 such as the cooling system may be monitored. As shown in FIG. 3B a portion of power supplied to the switchboard 320 is supplied to the mechanical load 205. As the first UPS 100 and/or second UPS 240 generate heat, a cooling system acting as the mechanical load 205 will operate to maintain the data center, facility, or enclosure including the first UPS 100 and/or second UPS 240 at a desired temperature. Operational parameters of portions of the switchboard 320 supplying power to the cooling system as well as operating parameters of the cooling system itself, for example, power quality of power supplied to the cooling system, test and balance parameters of the cooling system, or other parameters may be monitored either automatically by a controller 112 of the first or second UPS 100, 240 or an external system 122 controlling the testing, or by an operator observing the testing to verify that the cooling system functions as expected.

An alert signal may be generated by a control system (for example, the controller 112 of with the first or second UPS or an external system 122) performing the testing of the UPS 100 and other components responsive to an operational parameter of one of a switchboard 320, 330 or a circuit breaker in an electrical circuit with the first UPS system 100 being outside of predefined specification while the first UPS system 100 is maintaining the magnitude of the power delivered from the output of the first UPS system 100 to the inlet of the second UPS system 240. The operational parameter may include any one or more of temperature, active power, reactive power, voltage harmonics, or current harmonics. The control system may also provide an alert signal responsive to an operational parameter of a mechanical load 205 such as a cooling system disposed in the enclosure 200 with the first UPS system 100 being outside of predefined specification while the first UPS system 100 is maintaining the magnitude of the power delivered from the output of the first UPS system 100 to the inlet of the second UPS system 240. The alert signal may be in the form of an audible or visual alarm generated by or on the external system 122, a text message, an e-mail, or a phone call sent from the external system 122 to an owner or operator of the facility or enclosure 200 and/or to a service person responsible for commissioning or maintaining operation of equipment within the facility or enclosure 200, or any other form of alert.

In some embodiments, if a monitored operational parameter of any system under test (the UPS 100, the switchboards 320, 330, the mechanical load 205, etc.) is outside of its respective predetermined specification, the external system 122 or the controller 112 of the first or second UPS 100, 240 may automatically terminate the testing and terminate the looping of power between the first or second UPSs 100, 240. This may occur if an alert signal is generated responsive to the value of the operational parameter being out of specification or, alternatively, even if the alert signal is not generated responsive to the value of the operational parameter being out of specification. In other embodiments, the testing is not automatically terminated by the external system 122 or the controller 112 of the first or second UPS 100, 240 responsive to the value of the operational parameter being out of specification but rather may be terminated at the discretion of and by an operator that is performing the testing and observing any one or more operational parameters of any system under test, for example, utilizing the external system 122. The operator may have the possibility of terminating the testing and the loop of power between the first and second UPSs 100, 240, for example, utilizing the external system 122 even if no operational parameters of any equipment being monitored appears to be out of specification.

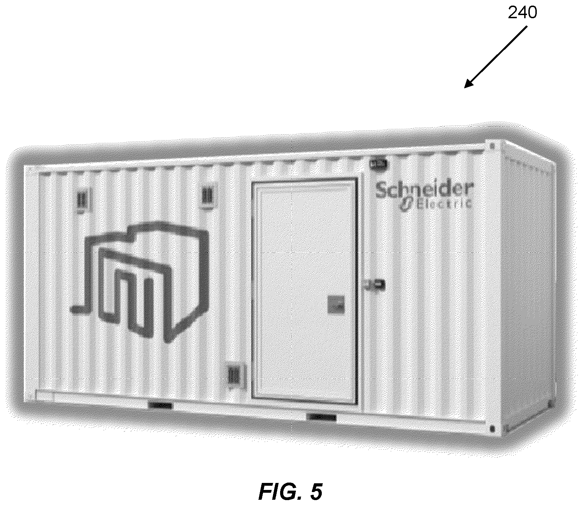

In some embodiments, the second UPS system 240 may be installed in and housed in a mobile container, for example, a 20 foot shipping container (See FIG. 5) so that it can be transported to a facility at which it is needed and then removed once it is no longer needed at the facility. Indicator 240 may thus refer not only to the second UPS system, but also the mobile container it is disposed within.

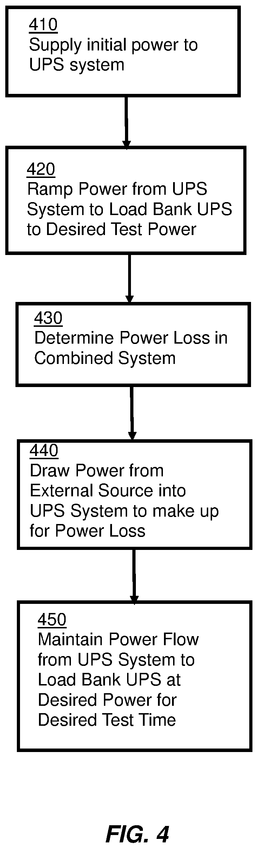

FIG. 4 is a flowchart of a method of performance testing of a UPS system in accordance with the present disclosure. The method may be performed by a control system of a UPS test system, which may include the controller 112 of a first or second UPS 100, 240 as disclosed herein or by a separate control system, for example, an external system 122 as illustrated in FIG. 1A in communication with the controller 112 of the first or second UPS 100, 240.

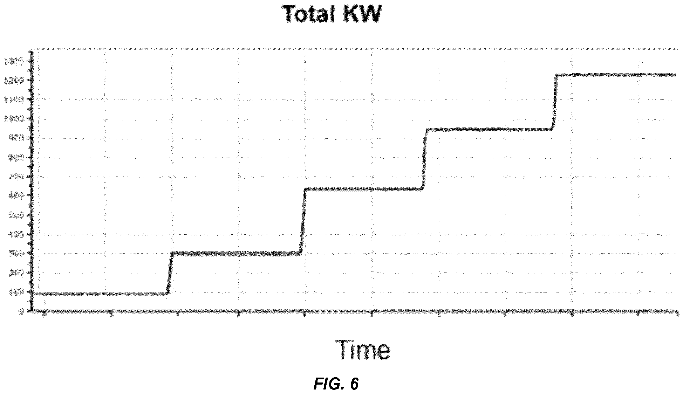

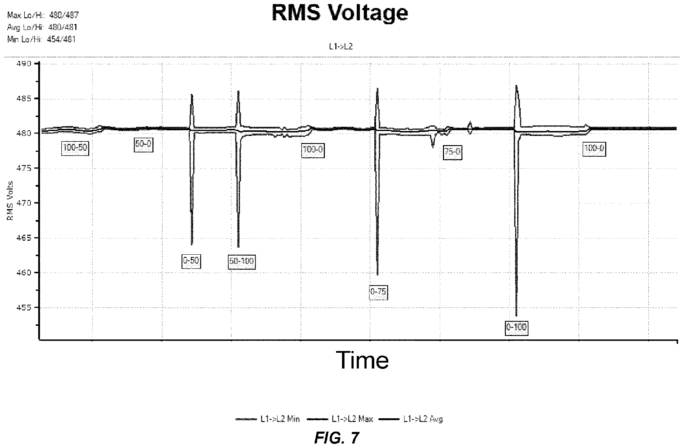

The method begins at act 410 in which testing of the UPS system, for example, first UPS 100 is initiated and in which an initial amount of power is supplied to the first UPS 100 from an external source 260. In act 420 a magnitude of power output by the first UPS system 100 and supplied to a load bank UPS, for example, the second UPS 240, is ramped up to a desired test power. This may occur as additional power from the external source 260 is supplied to the first UPS 100 at a higher rate than power is lost while recirculating through the first and second UPS systems 100, 240 and the additional power combines with power recirculated from the second UPS 240 to the first UPS 100 until the total power circulating through the first and second UPS systems 100, 240 reaches a desired test power. The desired test power may be equal to, greater than, or less than an amount of power that a facility supported by the UPS may be provided with responsive to failure of mains power and may be equal to or greater than a full rated capacity of the fist UPS system 100. During supply of the test power to the second UPS 240 parameters such as power quality of power output from the first UPS 1000 may be monitored. The control system performing the testing of the first UPS system 100 may vary the magnitude of the power delivered from the output of the first UPS system to the inlet of the second UPS system 240. The control system may provide an alert signal responsive to a change in output voltage of the first UPS system 100 being outside of a predefined specification responsive to a change in the magnitude of power supplied by the first UPS system 100 to the inlet of the second UPS system 240. In some embodiments, the test power may be provided as a series of high power step loads as illustrated in FIG. 6. When applying the power as step loads, transient tests may be performed by measuring the change in the voltage at the output of the first UPS 100 at one or more of the times when the total power output changes (See FIG. 7) to determine if the voltage deviation is within specified limits or not. In act 430 an amount of power lost as power circulates through the first UPS 100 and second UPS 240 is determined, for example, by monitoring a voltage or current at one or more points in the current circulation loop including the UPS 100 and second UPS 240. In act 440 power is drawn into the UPS system, for example, into a power inlet of the first UPS system 100 from an external source 260 which may be mains power, a generator, or another source of power. In act 450 power flow from the first UPS 100 to the second UPS 240 is maintained at the desired magnitude of power for a desired time of the performance test.

In some embodiments a control system of a UPS test system upon which the method is performed may provide an alert signal responsive to detection of an operational parameter of a component of the first UPS system 100 being outside of a predefined specification or responsive to failure of a component of the first UPS system 100 while the first UPS system 100 is maintaining the magnitude of the power delivered from the output of the first UPS system 100 to the inlet of the second UPS system 240. The control system may also provide an alert signal responsive to the first UPS system 100 being unable to maintain the magnitude of the power delivered from the output of the first UPS system 100 to the inlet of the second UPS system 240. In other embodiments, the control system of a UPS test system upon which the method is performed may terminate the method responsive to an operational parameter of a component of the first UPS system 100 or other system under test being outside of a predefined specification or responsive to failure of a component of the first UPS system 100 or other system under test in addition to or as an alternative to providing the alert signal.

In some embodiments, the second UPS system 240 is housed in a portable container that is delivered to a location of the first UPS 100 prior to the method being performed and that is removed after the method is completed.

It is to be appreciated that this disclosure also contemplates a UPS, for example, a UPS 100 as illustrated in FIG. 1A with a controller 112 configured to perform embodiments of the method described above as well as a non-transitory computer readable media having instructions encoded therein which, when executed by a UPS or UPS test system, cause the UPS or UPS test system to perform embodiments of the method described above.

Having thus described several aspects of at least one embodiment, it is to be appreciated various alterations, modifications, and improvements will readily occur to those skilled in the art. Such alterations, modifications, and improvements are intended to be part of, and within the scope of, this disclosure. Accordingly, the foregoing description and drawings are by way of example only.

Further examples are provided in the following clauses:
Clause 1. A non-transitory computer readable media having instruction encoded thereon which, when executed by a control system of an uninterruptible power supply (UPS) test system, cause the UPS test system to deliver power from an output of a first UPS system to an inlet of a second UPS system, receive power from an outlet of the second UPS system at an inlet of the first UPS system, and maintain a magnitude of the power delivered from the output of the first UPS system to the inlet of a second UPS system at a desired level.
Clause 2. The computer readable media of clause 1, wherein the instructions further cause the control system to maintain the magnitude of the power delivered from the output of the first UPS system to the inlet of the second UPS system by drawing power from an external source into the inlet of the first UPS system.
Clause 3. The computer readable media of clause 1, wherein the instructions further cause the control system to maintain the magnitude of the power delivered from the output of the first UPS system to the inlet of the second UPS system by drawing power from an external source into the inlet of the first UPS system in amount sufficient to make up for power losses exhibited in a current loop including the first and second UPS systems.
Clause 4. The computer readable media of clause 1, wherein the instructions further cause the control system to maintain the magnitude of the power delivered from the output of the first UPS system to the inlet of the second UPS system by controlling operation of a generator configured to deliver power to the inlet of the first UPS system.
Clause 5. The computer readable media of clause 1, wherein the instructions further cause the control system to maintain the magnitude of the power delivered from the output of the first UPS system to the inlet of a second UPS system by drawing utility power into the inlet of the first UPS system.
Clause 6. The computer readable media of clause 1, wherein the instructions further cause the control system to provide an alert signal responsive to detection of an operational parameter of a component of the first UPS system being outside of a predefined specification while the first UPS system is maintaining the magnitude of the power delivered from the output of the first UPS system to the inlet of the second UPS system.
Clause 7. The computer readable media of clause 6, wherein the operational parameter of the component of the first UPS system includes power quality.
Clause 8. The computer readable media of clause 1, wherein the instructions further cause the control system to vary the magnitude of the power delivered from the output of the first UPS system to the inlet of the second UPS system.
Clause 9. The computer readable media of clause 8, wherein the instructions further cause the control system to provide an alert signal responsive to a change in output voltage of the first UPS system being outside of a predefined specification responsive to a change in the magnitude of power supplied by the first UPS system to the inlet of the second UPS system.
Clause 10. The computer readable media of clause 1, wherein the instructions further cause the control system to provide an alert signal responsive to failure of a component of the first UPS system while the first UPS system is maintaining the magnitude of the power delivered from the output of the first UPS system to the inlet of the second UPS system.
Clause 11. The computer readable media of clause 1, wherein the instructions further cause the control system to provide an alert signal responsive to the first UPS system being unable to maintain the magnitude of the power delivered from the output of the first UPS system to the inlet of the second UPS system.
Clause 12. The computer readable media of clause 1, wherein the instructions further cause the control system to ramp the magnitude of the power delivered from the output of the first UPS system to the inlet of the second UPS system from zero to a predetermined magnitude responsive to initiating testing of the first UPS system.
Clause 13. A method comprising delivering power from an output of a first uninterruptible power supply (UPS) system to an inlet of a second UPS system, receiving power from an outlet of the second UPS system at an inlet of the first UPS system, and maintaining a magnitude of the power delivered from the output of the first UPS system to the inlet of a second UPS system at a desired level.
Clause 14. The method of clause 13, further comprising delivering the second UPS system to a location of the first UPS system in a mobile container.
Clause 15. The method of clause 13, further comprising removing a mobile container housing the second UPS system from a location of the first UPS system.
Clause 16. The method of clause 13, further comprising installing a used UPS system as the second UPS system within a mobile container.
Clause 17. The method of clause 13, wherein maintaining the magnitude of the power delivered from the output of the first UPS system to the inlet of the second UPS system includes drawing power from an external source into the inlet of the first UPS system.
Clause 18. The method of clause 13, wherein maintaining the magnitude of the power delivered from the output of the first UPS system to the inlet of the second UPS system includes drawing power from an external source into the inlet of the first UPS system in amount sufficient to make up for power losses exhibited in a current loop including the first and second UPS systems.
Clause 19. The method of clause 13, wherein maintaining the magnitude of the power delivered from the output of the first UPS system to the inlet of the second UPS system includes controlling operation of a generator configured to deliver power to the inlet of the first UPS system.
Clause 20. The method of clause 13, wherein maintaining the magnitude of the power delivered from the output of the first UPS system to the inlet of the second UPS system includes drawing utility power into the inlet of the first UPS system.
Clause 21. The method of clause 13, further comprising checking at least one operational parameter of at least one component of the first UPS system while the first UPS system is maintaining the magnitude of the power delivered from the output of the first UPS system to the inlet of the second UPS system.
Clause 22. The method of clause 13, further comprising providing an alert signal responsive to detection of an operational parameter of a component of the first UPS system being outside of a predefined specification while the first UPS system is maintaining the magnitude of the power delivered from the output of the first UPS system to the inlet of the second UPS system.
Clause 23. The method of clause 22, wherein the operational parameter of the component of the first UPS system includes power quality.
Clause 24. The method of clause 13, further comprising varying the magnitude of the power delivered from the output of the first UPS system to the inlet of the second UPS system.
Clause 25. The method of clause 24, further comprising providing an alert signal responsive to a change in output voltage of the first UPS system being outside of a predefined specification responsive to a change in the magnitude of power supplied by the first UPS system to the inlet of the second UPS system.
Clause 26. The method of clause 13, further comprising providing an alert signal responsive to failure of a component of the first UPS system while the first UPS system is maintaining the magnitude of the power delivered from the output of the first UPS system to the inlet of the second UPS system.
Clause 27. The method of clause 13, further comprising providing an alert signal responsive to the first UPS system being unable to maintain the magnitude of the power delivered from the output of the first UPS system to the inlet of the second UPS system.
Clause 28. The method of clause 13, further comprising ramping the magnitude of the power delivered from the output of the first UPS system to the inlet of the second UPS system from zero to a predetermined magnitude responsive to initiating testing of the first UPS system.
Clause 29. The method of clause 13, further comprising providing an alert signal responsive to an operational parameter of one of a switchboard or a circuit breaker in an electrical circuit with the first UPS system being outside of predefined specification while the first UPS system is maintaining the magnitude of the power delivered from the output of the first UPS system to the inlet of the second UPS system.
Clause 30. The method of clause 29, wherein the operational parameter includes one of temperature, active power, reactive power, voltage harmonics, or current harmonics.
Clause 31. The method of clause 13, further comprising providing an alert signal responsive to an operational parameter of a cooling system disposed in an enclosure with the first UPS system being outside of predefined specification while the first UPS system is maintaining the magnitude of the power delivered from the output of the first UPS system to the inlet of the second UPS system.
Clause 32. A UPS test system comprising a first uninterruptible power supply (UPS) system, and a second UPS system, and a controller configured to cause the UPS test system to perform a method comprising delivering power from an output of the first uninterruptible power supply (UPS) system to an inlet of the second UPS system, receiving power from an outlet of the second UPS system at an inlet of the first UPS system, and maintaining a magnitude of the power delivered from the output of the first UPS system to the inlet of a second UPS system at a desired level.
Clause 33. The system of clause 32, wherein the second UPS system is disposed within a mobile container.
Clause 34. The system of clause 32, wherein the controller is further configured to maintain the magnitude of the power delivered from the output of the first UPS system to the inlet of the second UPS system by drawing power from an external source into the inlet of the first UPS system.
Clause 35. The system of clause 32, wherein the controller is further configured to maintain the magnitude of the power delivered from the output of the first UPS system to the inlet of the second UPS system by drawing power from an external source into the inlet of the first UPS system in amount sufficient to make up for power losses exhibited in a current loop including the first and second UPS systems.
Clause 36. The system of clause 32, wherein the controller is further configured to maintain the magnitude of the power delivered from the output of the first UPS system to the inlet of the second UPS system by controlling operation of a generator configured to deliver power to the inlet of the first UPS system.
Clause 37. The system of clause 32, wherein the controller is further configured to maintain the magnitude of the power delivered from the output of the first UPS system to the inlet of the second UPS system by drawing utility power into the inlet of the first UPS system.
Clause 38. The system of clause 32, wherein the controller is further configured to provide an alert signal responsive to detection of an operational parameter of a component of the first UPS system being outside of a predefined specification while the first UPS system is maintaining the magnitude of the power delivered from the output of the first UPS system to the inlet of the second UPS system.
Clause 39. The system of clause 32, wherein the controller is further configured to provide an alert signal responsive to failure of a component of the first UPS system while the first UPS system is maintaining the magnitude of the power delivered from the output of the first UPS system to the inlet of the second UPS system.
Clause 40. The system of clause 32, wherein the controller is further configured to provide an alert signal responsive to the first UPS system being unable to maintain the magnitude of the power delivered from the output of the first UPS system to the inlet of the second UPS system.
Clause 41. The system of clause 32, wherein the controller is further configured to ramp the magnitude of the power delivered from the output of the first UPS system to the inlet of the second UPS system from zero to a predetermined magnitude responsive to initiating testing of the first UPS system.

## Claims

1. A method comprising:
delivering power from an output of a first uninterruptible power supply (UPS) system to an inlet of a second UPS system;
receiving power from an outlet of the second UPS system at an inlet of the first UPS system; and
maintaining a magnitude of the power delivered from the output of the first UPS system to the inlet of a second UPS system at a desired level.

2. The method of claim 1, wherein maintaining the magnitude of the power delivered from the output of the first UPS system to the inlet of the second UPS system includes drawing power from an external source into one of the inlet of the first UPS system or the inlet of the second UPS system.

3. The method of claims 1 or 2, further comprising checking at least one operational parameter of at least one component of the first UPS system while the first UPS system is maintaining the magnitude of the power delivered from the output of the first UPS system to the inlet of the second UPS system and providing an alert signal responsive to detection of the at least one operational parameter of the at least one component of the first UPS system being outside of a predefined specification while the first UPS system is maintaining the magnitude of the power delivered from the output of the first UPS system to the inlet of the second UPS system.

4. The method of any of the above claims, further comprising varying the magnitude of the power delivered from the output of the first UPS system to the inlet of the second UPS system and providing an alert signal responsive to a change in output voltage of the first UPS system being outside of a predefined specification responsive to a change in the magnitude of power supplied by the first UPS system to the inlet of the second UPS system.

5. The method of any of the above claims, further comprising providing an alert signal responsive to failure of a component of the first UPS system while the first UPS system is maintaining the magnitude of the power delivered from the output of the first UPS system to the inlet of the second UPS system.

6. The method of any of the above claims, further comprising providing an alert signal responsive to the first UPS system being unable to maintain the magnitude of the power delivered from the output of the first UPS system to the inlet of the second UPS system.

7. The method of any of the above claims, further comprising providing an alert signal responsive to an operational parameter of one of a switchboard or a circuit breaker in an electrical circuit with the first UPS system being outside of predefined specification while the first UPS system is maintaining the magnitude of the power delivered from the output of the first UPS system to the inlet of the second UPS system.

8. The method of any of the above claims, further comprising providing an alert signal responsive to an operational parameter of a cooling system disposed in an enclosure with the first UPS system being outside of predefined specification while the first UPS system is maintaining the magnitude of the power delivered from the output of the first UPS system to the inlet of the second UPS system.

9. A UPS test system comprising:
a first uninterruptible power supply (UPS) system; and
a second UPS system; and
a controller configured to cause the UPS test system to perform a method comprising:
delivering power from an output of the first uninterruptible power supply (UPS) system to an inlet of the second UPS system;
receiving power from an outlet of the second UPS system at an inlet of the first UPS system; and
maintaining a magnitude of the power delivered from the output of the first UPS system to the inlet of a second UPS system at a desired level.

10. The system of claim 9, wherein the controller is further configured to maintain the magnitude of the power delivered from the output of the first UPS system to the inlet of the second UPS system by drawing power from an external source into one of the inlet of the first UPS system or the inlet of the second UPS system.

11. The system of claims 9 or 10, wherein the controller is further configured to maintain the magnitude of the power delivered from the output of the first UPS system to the inlet of the second UPS system by one of controlling operation of a generator configured to deliver power to the inlet of the first UPS system or by drawing utility power into the inlet of the first UPS system.

12. The system of any of the claims 9 to 11, wherein the controller is further configured to provide an alert signal responsive to detection of an operational parameter of a component of the first UPS system being outside of a predefined specification while the first UPS system is maintaining the magnitude of the power delivered from the output of the first UPS system to the inlet of the second UPS system.

13. The system of any of the claims 9 to 12, wherein the controller is further configured to provide an alert signal responsive to failure of a component of the first UPS system while the first UPS system is maintaining the magnitude of the power delivered from the output of the first UPS system to the inlet of the second UPS system.

14. The system of any of the claims 9 to 13, wherein the controller is further configured to provide an alert signal responsive to the first UPS system being unable to maintain the magnitude of the power delivered from the output of the first UPS system to the inlet of the second UPS system.

15. A non-transitory computer readable media having instruction encoded thereon which, when executed by a control system of an uninterruptible power supply (UPS) test system according to any of claims 9 to 14, cause the UPS test system to operate according to any of the method claims 1 to 8.
